# EUROPÄISCHE PATENTSCHRIFT

(11) **EP 3 152 985 B1**
(45) Veröffentlichungstag und Bekanntmachung des Hinweises auf die Patenterteilung: **10.07.2019**
(21) Anmeldenummer: 15725331.1
(22) Anmeldetag: 27.05.2015
(51) Int. Cl.: H05K 1/03, H05K 3/28, H05K 1/18, H05K 3/02, H05K 3/34, H05K 3/20, H05K 3/24

(54) **VERFAHREN ZUM HERSTELLEN EINER FOLIENANORDNUNG UND ENTSPRECHENDE FOLIENANORDNUNG**
METHOD FOR PRODUCING A FOIL ARRANGEMENT AND CORRESPONDING FOIL ARRANGEMENT
PROCÉDÉ DE PRODUCTION D'UN ARRANGEMENT DE FEUILLES ET ARRANGMENT DE FEUILLES CORRESPONDANT

(30) Priorität: 03.06.2014 DE 102014210483
(43) Veröffentlichungstag der Anmeldung: 12.04.2017
(73) Patentinhaber: Conti Temic microelectronic GmbH, 90411 Nürnberg (DE)
(72) Erfinder: BOCK, Johannes, 91056 Erlangen (DE); REBELEIN, Andreas, 91233 Neunkirchen a. Sand (DE); SCHULZE, Andreas, 91207 Lauf a. d. Peg. / OT Neunhof (DE); VÖGERL, Andreas, 92331 Parsberg (DE)
(74) Vertreter: Bonn, Roman Klemens
(86) Internationale Anmeldenummer: PCT/EP2015/061709
(87) Internationale Veröffentlichungsnummer: WO 2015/185412

(56) Entgegenhaltungen:
- EP-A1- 0 321 067
- EP-A2- 0 175 045
- US-A- 5 590 465
- US-A1- 2006 108 145
- US-A1- 2007 190 847

## Beschreibung

### Technisches Gebiet

Die vorliegende Erfindung betrifft ein Verfahren zum Herstellen einer Folienanordnung und eine entsprechende Folienanordnung.

### Technischer Hintergrund

Es existiert bereits eine Reihe von Verfahren zur Einbettung von Halbleiterbauteilen in biegsame Substrate oder Folienanordnungen, welche zum Teil bereits in der Fertigung eingesetzt werden.

Aus der US 2007/0227761 A1 ist beispielsweise ein Verfahren zum Einbetten von elektronischen Komponenten beschrieben, bei dem die elektronische Komponente auf eine Folienanordnung aus leitender Schicht und Trägerfolie mittels einer Klebeschicht aufgesetzt wird und von einer isolierenden Masse umgeben wird.

Die Trägerschicht wird bei dem dort beschriebenen Verfahren entfernt und von der Seite der leitenden Schicht werden Löcher gebohrt, um eine Verbindung zu den Bumps bzw. den Kontaktflächen des mindestens einen elektronischen Bauteils herzustellen.

Anschließend wird bei dem dort beschriebenen Verfahren die leitende Schicht mit einer Metallisierung versehen und beide werden entsprechend den Vorgaben strukturiert.

Die US 2006 108 145 A1 beschreibt ein Verfahren zur Herstellung einer gedruckten Leiterplatte mit einer Zwischen schicht-Isolationsschicht und einer Leiterschicht, ohne die Biegeleistung durch aktive Bindung zu reduzieren und, wobei auf der Oberfläche eines Leiterabschnitts der Leitschicht Metallkristalle abgeschieden werden.

Die EP 0 321 067 A1 beschreibt ein Verfahren zum Abscheiden von Kupfer auf eine Harzschicht, wobei durch Reduktion einer Kupferoxidschicht mit einer wässrigen Aldehyd-Lösung die Haftung verbessert, nachdem die Harzschicht mit Kupfer oder einem Metall edler als Kupfer in Kontakt gebracht wird, oder nachdem sie mit einer wässrigen Lösung von Alkali-Borhydrid in Kontakt gebracht wird.

Die US 5 590 465 A, die US 2007/190847 A1 und die EP 0 175 045 A2 beschreiben Verfahren zur Herstellung von durchkontaktierten flexiblen Leiterplatten.

Die DE 102009058764 A1 betrifft ein Verfahren zur Herstellung einer elektronischen Baugruppe, bei der mindestens ein elektronisches Bauteil in ein isolierendes Material zumindest teilweise eingebettet ist.

Das dort beschriebene Verfahren umfasst die Schritte:
Bereitstellen einer Folienanordnung, die mindestens eine leitfähige Schicht und eine Trägerschicht aufweist, Strukturieren der leitfähigen Schicht, der Folienanordnung derart, dass Öffnungen für die Aufnahme von Bumps hergestellt werden, die mit den Kontaktflächen des mindestens einen elektronischen Bauteils verbunden sind.

Ferner umfasst das dort beschriebene Verfahren ein Aufbringen einer Klebeschicht auf die mit Öffnungen versehene leitfähige Schicht, Aufsetzen des mindestens einen Bauteils auf die Folienanordnung, Abscheiden einer Metallisierungsschicht auf die Seite der leitenden Schicht mit den freigelegten Bumps.

### Zusammenfassung der Erfindung

Der vorliegenden Erfindung liegt somit die Aufgabe zugrunde, ein verbessertes Verfahren zur Herstellung einer Folienanordnung zu schaffen.

Die Aufgabe wird durch die Merkmale der unabhängigen Ansprüche gelöst.

Demgemäß ist nach einem ersten Aspekt der vorliegenden Erfindung ein Verfahren zum Herstellen einer Folienanordnung vorgesehen, wobei das Verfahren die folgenden Verfahrensschritte umfasst: Strukturieren einer auf einer Trägerfolienoberseite einer Trägerfolie aufgebrachten oder aufzubringenden Leitfolie; Beschichten einer Leitfolienoberseite der strukturierten Leitfolie mit einer Schutzschicht; und Auflaminieren einer Deckfolie auf die Trägerfolienoberseite und auf eine Schutzschichtoberseite der Schutzschicht nach dem Beschichten.

Mit anderen Worten ausgedrückt kann das Strukturieren der Leitfolie vor oder nach dem Aufbringen erfolgen. Ferner kann das Beschichten der Leitfolie vor oder nach dem Aufbringen erfolgen.

Nach einem zweiten Aspekt der vorliegenden Erfindung ist eine Folienanordnung vorgesehen, beispielsweise herstellbar nach einem Verfahren nach einer Ausführungsform des ersten Aspektes, wobei die Folienanordnung umfasst: eine Trägerfolie mit einer Trägerfolienoberseite; eine auf der Trägerfolienoberseite aufgebrachte Leitfolie mit einer Strukturierung; eine auf einer Leitfolienoberseite aufgebrachte Schutzschicht mit einer Schutzschichtoberseite; und eine auf der Trägerfolienoberseite und der Schutzschichtoberseite auflaminierte Deckfolie.

Vorteilhafte Ausgestaltungen der Erfindung sind in den Unteransprüchen gekennzeichnet.

Die der Erfindung zugrunde liegende Idee liegt darin, dass beim Folienfertigungsablauf die Oberflächenbeschichtung des Kupfers in einem vor dem Auflaminieren der Deckfolie durchzuführenden Fertigungsschritt aufgebracht wird, um Polyimid-Leiterfolien gegen Korrosion zu schützen.

Bringt man vorteilhafterweise die Oberflächenbeschichtung vor dem Auflaminieren der Deckfolie auf, so kann die Deckfolie und Oberflächenbeschichtung überdeckend ausgeführt werden und es ergibt sich kein Angriffspunkt für eine Korrosion der darunterliegenden Leitfolie mehr, vorzugweise Kupfer.

Des Weiteren kann die Auflaminierung gegebenenfalls auch für Leiterplatten verwendet werden, wie etwa Leiterplatten aus einem elektrisch isolierenden Material mit daran haftenden, leitenden Verbindungen (Leiterbahnen). Als isolierendes Material kann faserverstärkter Kunststoff verwendet werden. Die Leiterbahnen können aus einer dünnen Schicht Kupfer geätzt werden.

Die Folienanordnung kann als eine Flexleiterplatte, d.h. eine flexible Leiterplatte, etwa auf Basis von Polyimid-Folien ausgebildet sein.

Die unter Verwendung der Folienanordnung aufgebauten Flexschaltungen können platzsparend durch Falten in engsten Strukturen etwa in Fotoapparaten, Videokameras oder auch Smartphones oder Getriebesteuerungen, insbesondere in oder an dem Getriebe eingebaut bzw. angebracht, eingesetzt werden.

Flexible Verbindungen für dauernde Beanspruchung, beispielsweise in Tintenstrahldruckern, können ebenfalls als Polyimid-Folien-Leiterplatte ausgebildet sein.

In einer vorteilhaften Ausführungsform ist vorgesehen, dass das Beschichten ein Galvanisieren der der Leitfolienoberseite umfasst.

Dadurch kann vorteilhaft auf sichere Weise ein dauerhafter Korrosionsschutz bereitgestellt werden.

In einer weiteren bevorzugten Ausführungsform ist vorgesehen, dass vor dem Strukturieren der Leitfolie die Leitfolie auf die Trägerfolie aufgeklebt wird.

Dies erlaubt auf einfache Weise, die Leitfolie und die Trägerfolie mittels einer Klebung zu verbinden.

In einer weiteren bevorzugten Ausführungsform ist vorgesehen, dass nach dem Auflaminieren ein Bestücken der Folienanordnung mit Bauteilen erfolgt.

Dadurch kann vorteilhaft eine Montage erfolgen.

In einer weiteren bevorzugten Ausführungsform ist vorgesehen, dass bei dem Beschichten der strukturierten Leitfolie mit der Schutzschicht ein Überlappbereich gebildet wird.

Dadurch kann vorteilhaft ein dicht-schließender Korrosionsschutz bereitgestellt werden.

In einer weiteren bevorzugten Ausführungsform ist vorgesehen, dass die Leitfolie ein Metall, vorzugsweise Kupfer oder eine Kupfer-Legierung aufweist.

In einer weiteren bevorzugten Ausführungsform ist vorgesehen, dass die Schutzschicht eine galvanisierte Schicht aufweist. Beispielsweise kann die Schutzschicht auch in Form einer Heißluftmetallisierung oder einer Heißluftverzinnung aufgebracht werden, kurz HAL, HAL steht für Hot Air Leveling, (deutsch: Heißluftverzinnung) oder die Schutzschicht wird mittels eines chemischen Verfahrens ausgebildet, etwa eine chemische Metallisierung.

Beim HAL-Prozess werden beispielsweise Platinen in eine Führung oder Klammer eingespannt und in ein heißes Zinnbad eingetaucht.

In einer weiteren bevorzugten Ausführungsform ist vorgesehen, dass die galvanisierte Schicht Gold oder eine Gold-Legierung, Nickel oder eine Nickel-Legierung, Zinn oder eine Zinn-Legierung aufweist, oder eine Kombination aus Nickel Gold (NiAu) oder eine Kombination aus Nickel, Palladium und Gold (ENEPAG = electroless Nickel, electroless Palladium autokatalytisch Gold; ENEPIG = electroless Nickel, electroless Palladium, immersion Gold).

In einer weiteren bevorzugten Ausführungsform ist vorgesehen, dass die Trägerfolie ein Polyethylen oder ein Polyimid aufweist, vorzugsweise weist die Trägerfolie Polybismaleinimid, Polybenzimidazol, Polyoxadiazobenzimidazol, Polyimidsulfon oder Polymethacrylimid auf.

Die beschriebenen Ausgestaltungen und Weiterbildungen lassen sich beliebig miteinander kombinieren.

Weitere mögliche Ausgestaltungen, Weiterbildungen und Implementierungen der vorliegenden Erfindung umfassen auch nicht explizit genannte Kombinationen von zuvor oder im Folgenden bezüglich der Ausführungsbeispiele beschriebenen Merkmale der Erfindung.

### Kurze Beschreibung der Zeichnungen

Die beiliegenden Zeichnungen sollen ein weiteres Verständnis der Ausführungsformen der vorliegenden Erfindung vermitteln. Sie veranschaulichen Ausführungsformen und dienen im Zusammenhang mit der Beschreibung der Erklärung von Konzepten der vorliegenden Erfindung.

Andere Ausführungsformen und viele der genannten Vorteile ergeben sich im Hinblick auf die Zeichnungen. Die dargestellten Elemente der Zeichnungen sind nicht notwendigerweise maßstabsgetreu zueinander gezeigt.

Es zeigen:
- Fig. 1: eine schematische Darstellung einer Folienanordnung gemäß einer Ausführungsform der vorliegenden Erfindung;
- Fig. 2: eine schematische Darstellung einer Folienanordnung gemäß einer weiteren Ausführungsform der vorliegenden Erfindung;
- Fig. 3: eine schematische Darstellung einer Folienanordnung gemäß einer weiteren Ausführungsform der Erfindung;
- Fig. 4: eine schematische Darstellung einer Folienanordnung gemäß einer weiteren Ausführungsform der Erfindung;
- Fig. 5: eine schematische Darstellung eines Flussdiagramms eines Verfahrens zum Herstellen einer Folienanordnung gemäß einer weiteren Ausführungsform der Erfindung; und
- Fig. 6: eine schematische Darstellung einer Folienanordnung zur Erläuterung der Erfindung.

### Detaillierte Beschreibung von Ausführungsbeispielen

In den Figuren der Zeichnungen bezeichnen gleiche Bezugszeichen gleiche oder funktionsgleiche Elemente, Bauteile, Komponenten oder Verfahrensschritte, soweit nichts Gegenteiliges angegeben ist.

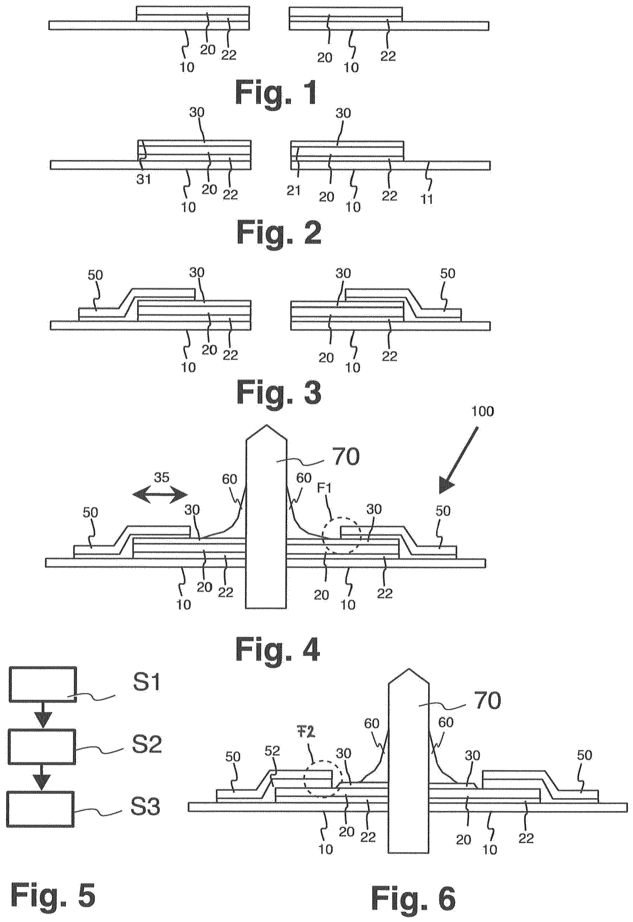

Die Figur 1 zeigt eine schematische Darstellung einer Folienanordnung gemäß einer Ausführungsform der vorliegenden Erfindung.

Eine Trägerfolie 10 weist beispielsweise eine Trägerfolienoberseite 11 auf. Es erfolgt ein
Strukturieren S1 einer auf der Trägerfolienoberseite 11 aufgebrachten Leitfolie 20, welche beispielsweise mittels einer Klebeschicht 22 aufgeklebt worden ist.

Die Figur 2 zeigt eine schematische Darstellung einer Folienanordnung gemäß einer Ausführungsform der vorliegenden Erfindung.

Ausgehend von dem in Figur 1 dargestellten Fertigungsgrad der Folienanordnung erfolgt in Figur 2 ein Beschichten S2 einer Leitfolienoberseite 21 der strukturierten Leitfolie 20 mit einer Schutzschicht 30, dies kann mittels einer Galvanisierung vorgenommen werden.

Die weiteren Bezugszeichen der Figur 2 sind bereits in den vorherigen Figurenbeschreibungen erläutert worden und werden daher nicht weiter beschrieben.

Die Figur 3 zeigt eine schematische Darstellung einer Folienanordnung gemäß einer Ausführungsform der vorliegenden Erfindung.

Ferner erfolgt ausgehend von dem in Figur 2 dargestellten Fertigungsgrad der Folienanordnung ein Auflaminieren S3 einer Deckfolie 50 auf die Trägerfolienoberseite 11 und auf eine Schutzschichtoberseite 31 der Schutzschicht 30 nach dem Beschichten S2.

Die weiteren Bezugszeichen der Figur 3 sind bereits in den vorherigen Figurenbeschreibungen erläutert worden und werden daher nicht weiter beschrieben.

Die Figur 4 zeigt eine schematische Darstellung einer Folienanordnung gemäß einer Ausführungsform der vorliegenden Erfindung.

Ein Anschlussbein 70 eines elektronischen Bauteils kann beispielsweise durch eine Lötverbindung 60 mit der strukturierten Leitfolie 20 verbunden werden, wobei bei dem Beschichten S3 der strukturierten Leitfolie 20 mit der Schutzschicht 50 ein Überlappbereich 35 gebildet wird.

In der Figur 4 ist eine Montage in Form einer Durchsteckmontage (englisch through-hole technology, THT; pin-in-hole technology, PIH) dargestellt. Die Durchsteckmontage ist dadurch gekennzeichnet, dass die Bauelemente Drahtanschlüsse haben ("bedrahtete Bauelemente").

Diese werden beispielsweise bei der Montage durch Kontaktlöcher in der Leiterplatte gesteckt und anschließend durch Löten, Handlöten, Wellenlöten oder Selektivlöten mit der Leiterbahn verbunden.

Die Folienanordnung 100 kann aber auch bei weiteren Montageweisen der Aufbau- und Verbindungstechnik verwendet werden, wie etwa bei einer Oberflächenmontage (engl.: surface-mounting technology, SMT) .

Der Überlappbereich 35 erlaubt, dass an den Korrosionsbereichen F1 die Leitfolie 20 vollständig mit der Schutzschicht 30 abgedeckt ist.

Die weiteren Bezugszeichen der Figur 4 sind bereits in den vorherigen Figurenbeschreibungen erläutert worden und werden daher nicht weiter beschrieben.

Die Figur 5 zeigt eine schematische Darstellung eines Flussdiagramms eines Verfahrens zum Herstellen einer Folienanordnung gemäß einer weiteren Ausführungsform der Erfindung.

Als ein erster Verfahrensschritt erfolgt ein Strukturieren S1 einer auf einer Trägerfolienoberseite 11 einer Trägerfolie 10 aufgebrachten Leitfolie 20.

Als ein zweiter Verfahrensschritt erfolgt ein Beschichten S2 einer Leitfolienoberseite 21 der strukturierten Leitfolie 20 mit einer Schutzschicht 30.

Beispielsweise kann als Schutzschicht 30 eine Nickel-Phosphorschicht chemisch - aussenstromlos - abgeschieden werden.

Ferner kann als Schutzschicht 30 eine elektrolytisch abgeschiedene Nickel-Phosphorschicht aufgetragen werden.

Für Anwendungen auf mechanisch hochbeanspruchten Leitfolien werden beispielsweise 2 bis 4 µm dicke Nickel-Phosphorschichten (elektrolytisch oder chemisch) abgeschieden.

Als ein dritter Verfahrensschritt erfolgt ein Auflaminieren S3 einer Deckfolie 50 auf die Trägerfolienoberseite 11 und auf eine Schutzschichtoberseite 21 der Schutzschicht 30 nach dem Beschichten S2.

Die Trägerfolie 10 kann als eine Polyethylen oder als eine Polyimidfolie ausgebildet sein und eine Polyimiddicke von bis zu 25 µm, bis zu 50 µm, bis zu 100 µm oder bis zu 500 µm aufweisen.

Die Trägerfolie 10 kann auch Polybismaleinimid (PBMI), Polybenzimidazol (PBI), Polyoxadiazobenzimidazol (PBO), Polyimidsulfon (PISO), Polymethacrylimid (PMI) oder Polyetherimide (PEI) oder Polyamidimide (PAI) aufweisen.

Die Leitfolie 20 kann als Kupferfolie ausgebildet werden und ein- oder doppelseitig mit einer Dicke von 18 µm, 35 µm, 70 µm oder 140 µm in Form von Walzkupfer, für dynamische Flexanwendungen geeignet, oder von elektrolytisch abgeschiedenen Kupfer aufweisen.

Dies ermöglicht vorteilhaft eine geringere Bruchdehnung.

Als Klebersysteme können Acrylkleber oder Epoxidkleber verwendet werden. Auch galvanotechnisch oder chemisch erzeugte, metallische Deckschichten aus Zinn, Gold, Nickel, Kupfer, Chrom, Palladium oder Legierungsschichten wie Nickel-Phosphor (chemisch Nickel) bewirken einen Korrosionsschutz durch das Ausbilden einer Schutzschicht 30 auf der Leitfolie 20.

Die Schutzwirkung basiert bei Metallschichten auf ihrer Eigenschaft, selbst nicht zu korrodieren (Edelmetalle oder z. B. bei Nickel eine spontane Selbstpassivierung) oder aber auf Passivieren des Grundmetalles durch Bildung einer dichten Oxidschicht auf der Oberfläche, die als Korrosionsschutz dient.

Die Figur 6 zeigt eine schematische Darstellung einer Folienanordnung zur Erläuterung der Erfindung.

Bei dem Beschichten der strukturierten Leitfolie von der in der Figur 6 dargestellten Folienanordnung mit der Schutzschicht 50 ist kein Überlappbereich 35 gebildet worden.

Folglich ist an den Korrosionsbereichen F2 die Leitfolie 20 nicht vollständig mit der Schutzschicht 30 abgedeckt.

Die weiteren Bezugszeichen der Figur 6 sind bereits in den vorherigen Figurenbeschreibungen erläutert worden und werden daher nicht weiter beschrieben.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar.

Insbesondere lässt sich die Erfindung in mannigfaltiger Weise verändern oder modifizieren, ohne vom Kern der Erfindung abzuweichen.

## Patentansprüche

1. Verfahren zum Herstellen einer Folienanordnung (100), wobei das Verfahren die folgenden Verfahrensschritte umfasst:
- Strukturieren (S1) einer auf einer Trägerfolienoberseite (11) einer Trägerfolie (10) aufgebrachten oder aufzubringenden Leitfolie (20);
- Beschichten (S2) einer Leitfolienoberseite (21) der strukturierten Leitfolie (20) mit einer gegen Korrosion schützenden Schutzschicht (30); und
- Auflaminieren (S3) einer Deckfolie (50) auf die Trägerfolienoberseite (11) und auf eine Schutzschichtoberseite (21) der Schutzschicht (30) nach dem Beschichten (S2) .

2. Verfahren nach Anspruch 1, wobei das Beschichten (S2) ein Galvanisieren der Leitfolienoberseite umfasst.

3. Verfahren nach Anspruch 1 oder 2, wobei vor dem Strukturieren (S1) der Leitfolie die Leitfolie auf die Trägerfolie aufgeklebt wird.

4. Verfahren nach einem der vorhergehenden Ansprüche 1 bis 3, wobei nach dem Auflaminieren (S3) ein Bestücken der Folienanordnung mit Bauteilen erfolgt.

5. Verfahren nach einem der vorhergehenden Ansprüche 1 bis 4, wobei bei dem Beschichten (S3) der strukturierten Leitfolie mit der Schutzschicht ein Überlappbereich (35) gebildet wird.

6. Folienanordnung, herstellbar nach einem Verfahren nach einem der vorhergehenden Ansprüche 1 bis 5, wobei die Folienanordnung (100) umfasst:
- eine Trägerfolie (10) mit einer Trägerfolienoberseite (11) ;
- eine auf der Trägerfolienoberseite (11) aufgebrachte Leitfolie (20) mit einer Strukturierung;
- eine auf einer Leitfolienoberseite (21) aufgebrachte gegen Korrosion schützende Schutzschicht (30) mit einer Schutzschichtoberseite (31); und
- eine auf der Trägerfolienoberseite (11) und der Schutzschichtoberseite (31) auflaminierte Deckfolie (50) .

7. Folienanordnung nach Anspruch 6,
wobei die Leitfolie (20) ein Metall, vorzugsweise Kupfer oder eine Kupfer-Legierung aufweist.

8. Folienanordnung nach Anspruch 6 oder 7,
wobei die Schutzschicht (30) eine galvanisierte Schicht aufweist.

9. Folienanordnung nach einem der Ansprüche 7 bis 8,
wobei die galvanisierte Schicht Gold oder eine Gold-Legierung, Nickel oder eine Nickel-Legierung, Zinn oder eine Zinn-Legierung aufweist.

10. Folienanordnung nach einem der Ansprüche 7 bis 9,
wobei die Trägerfolie (10) ein Polyethylen oder ein Polyimid aufweist, vorzugsweise weist die Trägerfolie (10) Polybismaleinimid, Polybenzimidazol, Polyoxadiazobenzimidazol, Polyimidsulfon oder Polymethacrylimid auf.

## Claims

1. Method for producing a foil arrangement (100), wherein the method comprises the following method steps:
- structuring (S1) a conductive foil (20) applied or to be applied to a carrier foil top side (11) of a carrier foil (10);
- coating (S2) a conductive foil top side (21) of the structured conductive foil (20) with a protective layer (30) protecting against corrosion; and
- laminating (S3) a cover foil (50) onto the carrier foil top side (11) and onto a protective layer top side (21) of the protective layer (30) after the coating (S2).

2. Method according to Claim 1, wherein the coating (S2) comprises electroplating of the conductive foil top side.

3. Method according to Claim 1 or 2, wherein, before the structuring (S1) of the conductive foil, the conductive foil is adhesively bonded to the carrier foil.

4. Method according to one of the preceding Claims 1 to 3, wherein the foil arrangement is populated with structural parts after the lamination (S3).

5. Method according to one of the preceding Claims 1 to 4, wherein an overlap region (35) is formed during the coating (S3) of the structured conductive foil with the protective layer.

6. Foil arrangement, producible by a method according to one of the preceding Claims 1 to 5, wherein the foil arrangement (100) comprises:
- a carrier foil (10) having a carrier foil top side (11);
- a conductive foil (20) applied to the carrier foil top side (11) and having a structuring;
- a protective layer (30) protecting against corrosion applied to a conductive foil top side (21) and having a protective layer top side (31); and
- a cover foil (50) laminated onto the carrier foil top side (11) and the protective layer top side (31).

7. Foil arrangement according to Claim 6,
wherein the conductive foil (20) comprises a metal, preferably copper or a copper alloy.

8. Foil arrangement according to Claim 6 or 7,
wherein the protective layer (30) comprises an electroplated layer.

9. Foil arrangement according to one of Claims 7 to 8,
wherein the electroplated layer comprises gold or a gold alloy, nickel or a nickel alloy, tin or a tin alloy.

10. Foil arrangement according to one of Claims 7 to 9,
wherein the carrier foil (10) comprises a polyethylene or a polyimide, the carrier foil (10) preferably comprising polybismaleimide, polybenzimidazole, polyoxadiazobenzimidazole, polyimide sulfone or polymethacrylimide.

## Revendications

1. Procédé de fabrication d'un arrangement de film (100), le procédé comprenant les étapes suivantes :
- structuration (S1) d'un film conducteur (20) appliqué ou à appliquer sur un côté supérieur de film porteur (11) d'un film porteur (10) ;
- revêtement (S2) d'un côté supérieur de film conducteur (21) du film conducteur (20) structuré avec une couche de protection (30) qui protège contre la corrosion ; et
- stratification (S3) d'un film de recouvrement (50) sur le côté supérieur de film porteur (11) et sur un côté supérieur de couche de protection (21) de la couche de protection (30) après le revêtement (S2).

2. Procédé selon la revendication 1, le revêtement (S2) comprenant une galvanisation du côté supérieur de film conducteur.

3. Procédé selon la revendication 1 ou 2, le film conducteur étant collé sur le film porteur avant la structuration (S1) du film conducteur.

4. Procédé selon l'une des revendications précédentes 1 à 3, une implantation de composants sur l'arrangement de film étant effectuée après la stratification (S3).

5. Procédé selon l'une des revendications précédentes 1 à 4, une zone de chevauchement (35) étant formée lors du revêtement (S3) du film conducteur structuré avec la couche de protection.

6. Arrangement de film, pouvant être fabriqué selon un procédé selon l'une des revendications précédentes 1 à 5, l'arrangement de film (100) comprenant :
- un film porteur (10) ayant un côté supérieur de film porteur (11) ;
- un film conducteur (20) appliqué sur le côté supérieur de film porteur (11) et ayant une structuration ;
- une couche de protection (30) qui protège contre la corrosion, appliquée sur un côté supérieur de film conducteur (21) et ayant un côté supérieur de couche de protection (31) ; et
- un film de recouvrement (50) stratifié sur le côté supérieur de film porteur (11) et le côté supérieur de couche de protection (31).

7. Arrangement de film selon la revendication 6, le film conducteur (20) possédant un métal, de préférence du cuivre ou un alliage de cuivre.

8. Arrangement de film selon la revendication 6 ou 7, la couche de protection (30) possédant une couche galvanisée.

9. Arrangement de film selon l'une des revendications 7 à 8, la couche galvanisée possédant de l'or ou un alliage d'or, du nickel ou un alliage de nickel, de l'étain ou alliage d'étain.

10. Arrangement de film selon l'une des revendications 7 à 9, le film porteur (10) possédant un polyéthylène ou un polyimide, le film porteur (10) possédant de préférence du polybismaléimide, du polybenzimidazole, du polyoxadiazole benzimidazole, du polyimide sulfone ou du polyméthacrylimide.
